# EUROPEAN PATENT APPLICATION

(11) **EP 4 791 143 A1**
(43) Date of publication of application: **12.08.2026**
(21) Application number: 25183496.6
(22) Date of filing: 17.06.2025
(51) Int. Cl.: H10D 30/01, H10D 30/66

(54) **SHORT-CHANNEL MOSFET DEVICE WITH LOW TURN-ON VOLTAGE AND MANUFACTURING METHOD THEREOF**

(30) Priority: 11.02.2025 CN 202510152804
(71) Applicant: Chongqing Alpha and Omega Semiconductor Limited, Chongqing 400700 (CN)
(72) Inventor: LUO, Huanxiang, Chongqing, 400700 (CN); YANG, Li, Chongqing, 400700 (CN)
(74) Representative: Metida

(57) **Abstract**

A short-channel MOSFET device with low turn-on voltage and a method for manufacturing the same are provided. The method includes providing a silicon wafer (100), and sequentially growing an epitaxial layer (200) and a first oxide layer (300) on the silicon wafer (100); performing a first ion implantation and a second ion implantation on an upper portion of the epitaxial layer (200) to form a body region (210) and a source region (220); etching to form gate trenches (230); growing a gate oxide layer (250) on trench walls of the gate trenches (230); forming gate polysilicon (500) in the gate trenches (230); and completing a subsequent manufacturing process of the short-channel MOSFET device. The body region (210) and the source region (220) are formed before forming the gate trenches (230), so conductive channels formed are not too short, and electronic leakage of the conductive channels is avoided.

## Description

### TECHNICAL FIELD

The present disclosure relates to a technical field of trench-type metal-oxide-semiconductor field-effect transistor (MOSFET) devices, and in particular to a short-channel MOSFET device with low turn-on voltage and a method for manufacturing the same.

### BACKGROUND

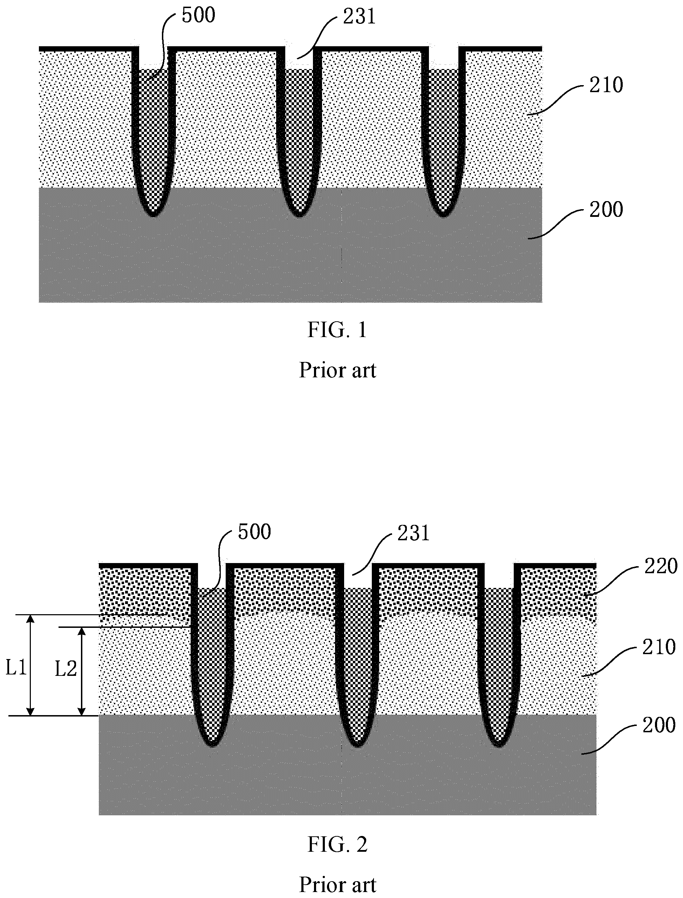

When designing a MOSFET device with low turn-on voltage, it is necessary to introduce a thin gate oxide process (i.e., the production of a thin gate oxide layer). As shown in FIG. 1, due to process limitations, the thin gate oxide process does not adopt a grinding process when removing polysilicon, and a dry etching process is adopted. In order to ensure that the polysilicon outside gate trenches is completely removed, the polysilicon is commonly over etched, which causes a certain amount of depressions in the polysilicon disposed in the gate trenches. As a result, recessed regions are formed.

Moreover, based on the demand for lower on-resistance, and a resistance of conductive channels of the MOSFET device with low turn-on voltage accounts for more than 30% of the on-resistance, benefits of optimizing the conductive channels are great, and the on-resistance is optimized by reducing a length of the conductive channels. In a conventional manufacturing process of the MOSFET device, a formation of active regions by ion implantation is performed after the polysilicon is etched. Since the recessed regions are formed in the polysilicon disposed in the gate trenches after etching the polysilicon, when the ion implantation is performed to form the active regions, some ions are implanted to the recessed regions on the polysilicon disposed in the gate trenches to form the active regions, resulting in depths of the active region near at the gate trenches being too deep, thus leading to longer conductive channels. As shown in FIG. 2, when the active regions formed by ion implantation do not have deep depths at the gate trenches, the length of the corresponding conductive channels should be L1. However, due to excessive depths of the active regions near the gate trenches, the length of the corresponding conductive channels becomes L2, resulting in a shorter length of the conductive channels. At this time, the reduction in the length of the conductive channels easily causes leakage in the conductive channels. The leakage problem is not well solved by the etching process, resulting in the inability of MOSFET devices with low turn-on voltage. MOSFET devices with short conductive channels to enter mass production.

### SUMMARY

In view of defects in the prior art, the present disclosure provides a short-channel MOSFET device with low turn-on voltage and a method for manufacturing the same.

To solve technical problems in the prior art, the present disclosure provides a method for manufacturing the short-channel MOSFET device with low turn-on voltage. The method comprises following steps:
S100: providing a silicon wafer, and sequentially growing an epitaxial layer and a first oxide layer on the silicon wafer;
S200: performing a first ion implantation and a second ion implantation on an upper portion of the epitaxial layer to form a body region and a source region;
S300: etching to form gate trenches;
S400: growing a gate oxide layer on trench walls of the gate trenches;
S500: forming gate polysilicon in the gate trenches; and
S600: completing a subsequent manufacturing process of the short-channel MOSFET device.

The present disclosure further provides the short-channel MOSFET device with low turn-on voltage. The short-channel MOSFET device with low turn-on voltage is manufactured by the method described above.

In the present disclosure, the body region is formed by performing the first ion implantation, then the source region is formed by performing the second ion implantation, and the gate trenches are formed by etching, so that a length of conductive channels prepared in the subsequent process is not affected by recessed regions formed by etching polysilicon, and portions of the source region near the gate trenches are prevented from being too deep, thereby avoiding that the conductive channels being too short. Thus, electric leakage of the conductive channels is avoided A temperature and a time of high-temperature processes are reduced by process improvement, and a situation that irons implanted to the body region and the source region may further diffuse when the high-temperature processes are performed is avoided, even though the body region and the source region are formed in advance by performing the first ion implantation and the second ion implantation. By respectively checking thicknesses of portions of gate oxide layer at the gate trenches corresponding to the source region and thicknesses of portions of gate oxide layer at the gate trenches corresponding to the body region, it is avoided that the thicknesses of the portions of the the gate oxide layer corresponding to the body region being inconsistent with the thicknesses of the portions of the the gate oxide layer corresponding to the source region when performing the first ion implantation and the second ion implantation in advance to form the body region and the source region, thereby avoiding that a thickness of a thinnest portion of the gate oxide layer being less than a minimum design thickness of the gate oxide layer.

### BRIEF DESCRIPTION OF DRAWINGS

FIG. 1 is a schematic diagram showing gate trenches with recessed regions caused by overetching in the prior art.
FIG. 2 is a schematic diagram showing a source region in the prior art where portions near the gate trenches are too deep caused by presence of the recessed regions.
FIG. 3 is a flow chart of a method for manufacturing a short-channel MOSFET device with low turn-on voltage of the present disclosure.
FIG. 4 is a schematic diagram of a silicon wafer after growing an epitaxial layer and a first oxide layer thereon of the present disclosure.
FIG. 5 is a schematic diagram of a structure obtained after forming and activating a body region on the silicon wafer shown in FIG. 4.
FIG. 6 is a schematic diagram of a structure obtained after forming a source region on the structure shown in FIG. 5.
FIG. 7 is a schematic diagram of a structure with gate trench regions obtained after etching the structure shown in FIG. 6.
FIG. 8 is a schematic diagram of a structure with gate trenches and with a first oxide layer and a first mask layer being removed obtained after etching the structure shown in FIG. 7.
FIG. 9 is a schematic diagram of a structure obtained after forming a sacrificial oxide layer on the structure shown in FIG. 8.
FIG. 10 is a schematic diagram of a structure obtained after removing the sacrificial oxide layer on the structure shown in FIG. 9.
FIG. 11 is a schematic diagram of a structure obtained after forming a gate oxide layer on the structure shown in FIG. 10.
FIG. 12 is a schematic diagram of a structure obtained after depositing polysilicon on the structure shown in FIG. 11.
FIG. 13 is a schematic diagram of a structure obtained after removing portions of the polysilicon outside the gate trenches of the structure shown in FIG. 12 by etching.
FIG. 14 is a schematic diagram of a structure obtained after a dielectric layer is deposited on the structure shown in FIG. 13.
FIG. 15 is a schematic diagram of a structure obtained after etching contact hole regions on the structure shown in FIG. 14.
FIG. 16 is a schematic diagram of a structure obtained after contact holes are formed on the structure shown in FIG. 15 by etching.
FIG. 17 is a schematic diagram of the short-channel MOSFET device with low turn-on voltage formed after a surface metal layer is deposited on the structure shown in FIG. 16.

### DETAILED DESCRIPTION

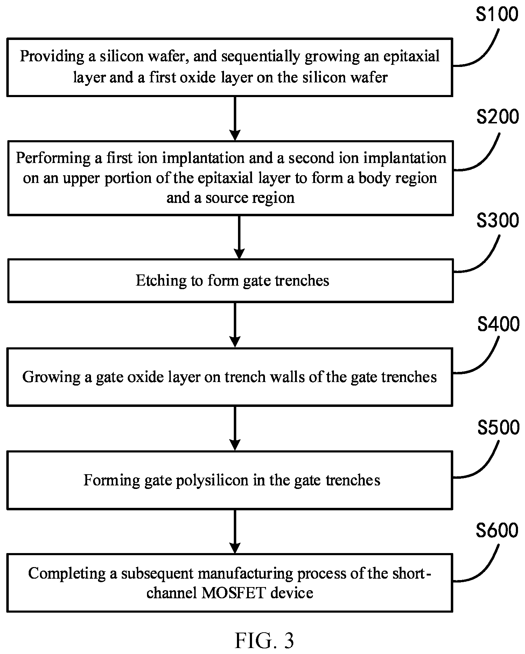

As shown in FIG. 3, FIG. 3 is a flow chart of a method for manufacturing a short-channel metal-oxide-semiconductor field-effect transistor (MOSFET) device with low turn-on voltage of the present disclosure. The method comprises steps S100-600.

As shown in FIG. 1, the step S100 comprises providing a silicon wafer 100, growing an epitaxial layer 200 on the silicon wafer 100, and growing a first oxide layer 300 on the epitaxial layer 200.

The step S200 comprises performing a first ion implantation and a second ion implantation on an upper portion of the epitaxial layer 200 to form a body region 210 and a source region 220. The step 200 specifically comprises steps S210-S220.

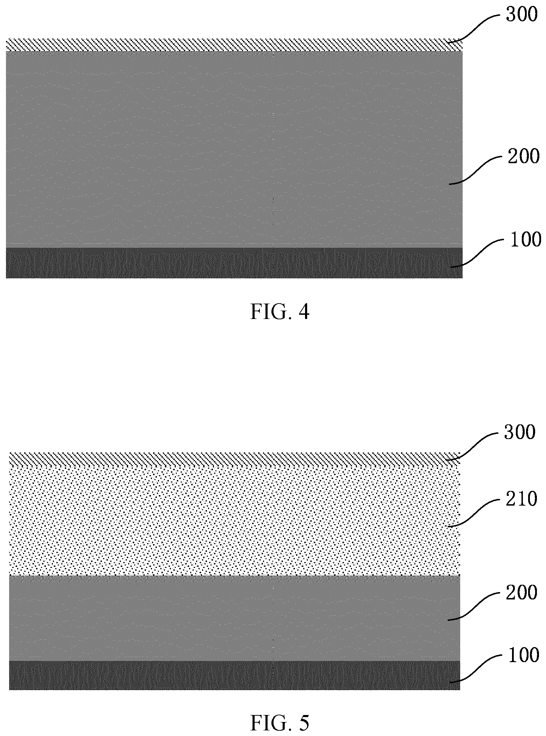

As shown in FIG. 5, the step S210 comprises performing the first ion implantation on the upper portion of the epitaxial layer 200 to form the body region 210, and performing a well drive-in process to activate the body region 210.

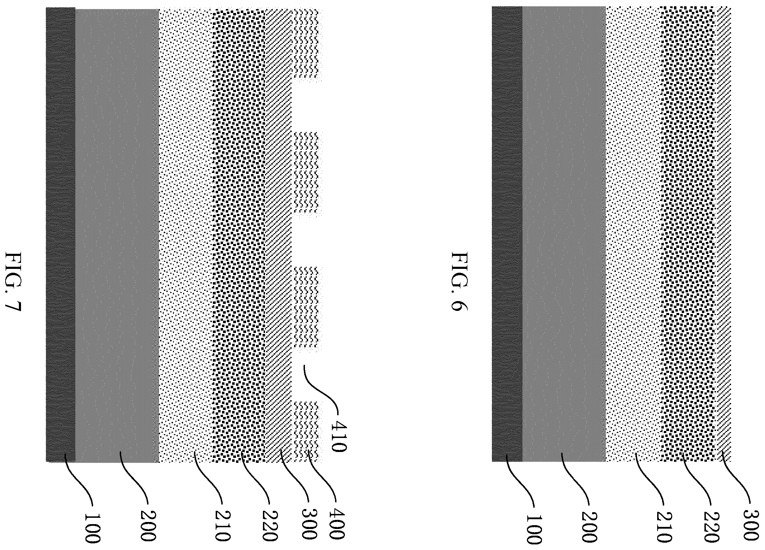

As shown in FIG. 6, the step S220 comprises performing the second ion implantation on an upper portion of the body region 210 to form the source region 220. In the embodiment, since the body region 210 and the source region 220 are formed in advance, after the source region 220 is formed, it is necessary to reduce a temperature and a time of a high temperature process in a subsequent process. For example, it is necessary to reduce a temperature and a time when forming a sacrificial oxide layer 240 and a gate oxide layer 250.

The step S300 comprises etching to form gate trenches 230. The step S300 specifically comprises steps S310-S340.

As shown in FIG. 7, the step S310 comprises growing a hard mask layer as a first mask layer 400 to facilitate a subsequent photolithography process.

As shown in FIG. 7, the step S320 comprises etching on the first mask layer 400 to form gate trench regions 410 by the photolithography process. The gate trench regions 410 are configured to form the gate trenches 230.

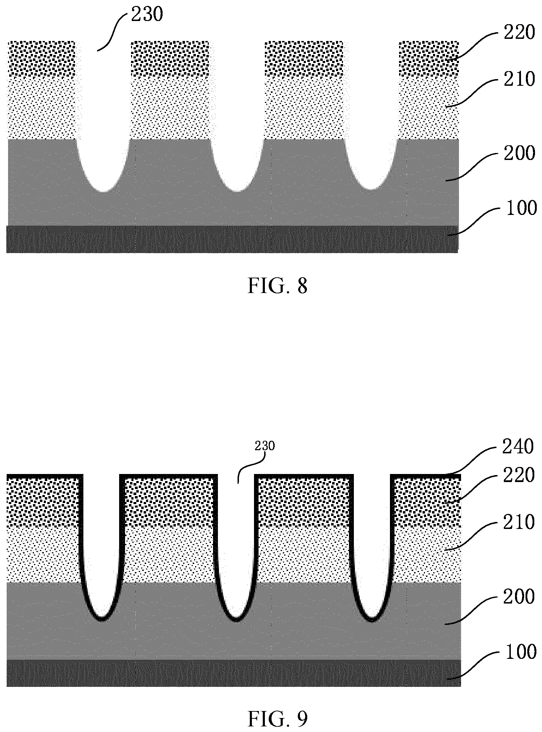

As shown in FIG. 8, the step S330 comprises etching downward in the gate trench regions 410 by an etching process to form the gate trenches 230. The gate trenches 230 penetrate through the body region 210 and the source region 220.

As shown in FIG. 8, the step S340 comprises removing the first oxide layer 300 and the first mask layer 400 disposed on the first oxide layer 300 after the gate trenches 230 are completely formed.

The step S400 comprises growing a gate oxide layer 250 on trench walls of the gate trenches 230. The step S400 specifically comprises steps S410-S430.

As shown in FIG. 9, the step S410 comprises growing a second oxide layer on the trench walls of the gate trenches 230 to form a sacrificial oxide layer 240. Since a relatively high temperature (generally above 1000°C) is required when forming the sacrificial oxide layer 240, and the present disclosure has previously formed the body region 210 and the source region 220 by ion implantation, in order to prevent the ions implanted into the body region 210 and the source region 220 from continuing to diffuse at the high temperature, the temperature for forming the sacrificial oxide layer 240 is reduced. Specifically, the sacrificial oxide layer 240 is grown and formed within a temperature range of 800°C to 900°C. At the same time, in order to avoid increasing the time due to lowering the temperature, a catalyst that is configured to accelerate a growth rate of the sacrificial oxide layer is introduced in the step, so that the time is not increased or even reduced when the temperature is lowered, and the diffusion of the ions implanted into the body region 210 and the source region 220 is reduced.

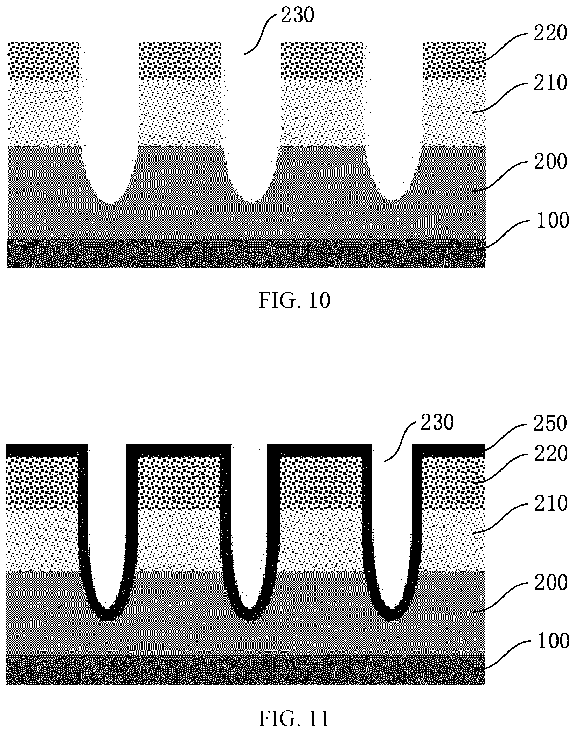

As shown in FIG. 10, the step S420 comprises etching to remove the sacrificial oxide layer 240. By removing the sacrificial oxide layer 240, damage on a surface thereof is removed.

As shown in FIG. 11, the step S430 comprises growing a third oxide layer on the trench walls of the gate trenches 230 to form the gate oxide layer 250. Similarly, in the step, the gate oxide layer 250 is grown in the temperature range of 800°C to 900°C, and the catalyst that is configured to accelerate the growth rate of the gate oxide layer is introduced in the step.

In addition, since the ions implanted into the source region 220 have a different polarity with the ions implanted into the body region 210, a growth rate of portions of the gate oxide layer on the gate trenches 230 corresponding to the source region 220 and the growth rate of portions of the gate oxide layer on the gate trenches 230 corresponding to the body region 210 are different. Therefore, after determining a minimum design thickness of the gate oxide layer 250 according to a gate withstand voltage requirement of the short-channel MOSFET device, it is necessary to check thicknesses of the portions of the gate oxide layer 250 on the gate trenches 230 corresponding to the source region 220 and thicknesses of the portions of the gate oxide layer 250 on the gate trenches 230 corresponding to the body region 210, so that the thicknesses of the portions of the gate oxide layer 250 on the gate trenches 230 corresponding to the source region 220 and the thicknesses of the portions of the gate oxide layer 250 on the gate trenches 230 corresponding to the body region 210 are not less than the minimum design thickness of the gate oxide layer 250.

The step S500 comprises forming gate polysilicon in the gate trenches 230. The step S500 specifically comprises steps S510-S520.

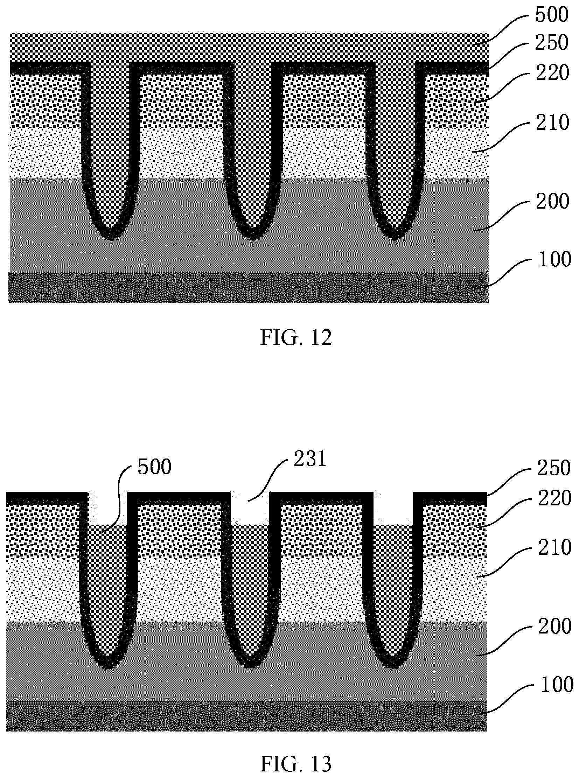

As shown in FIG. 12. the step S510 comprises depositing polysilicon 500 to enable the polysilicon 500 to fill the gate trenches 230. Of course, at this time, a layer of polysilicon 500 is formed on platforms on two sides of the gate trenches 230.

As shown in FIG. 13, the step S520 comprises removing portions of the polysilicon 500 outside the gate trenches 230 by dry etching. That is, the layer of polysilicon 500 formed on the platforms on two sides of the gate trenches 230 is removed. Of course, in order to ensure that the polysilicon 500 outside the gate trenches 230 is completely removed, there is a certain amount of over-etching in the step, so that a surface of the polysilicon 500 in each of the gate trenches 230 is lower than the platforms after etching, thereby forming recessed regions 231. Since the body region 210 and the source region 220 are formed in advance and are formed before the step S520, the recessed regions 231 do not lead to an excessively deep source region in the prior art.

The step S600 comprises completing a subsequent manufacturing process of the short-channel MOSFET device. The step S600 specifically comprises steps S610-S650.

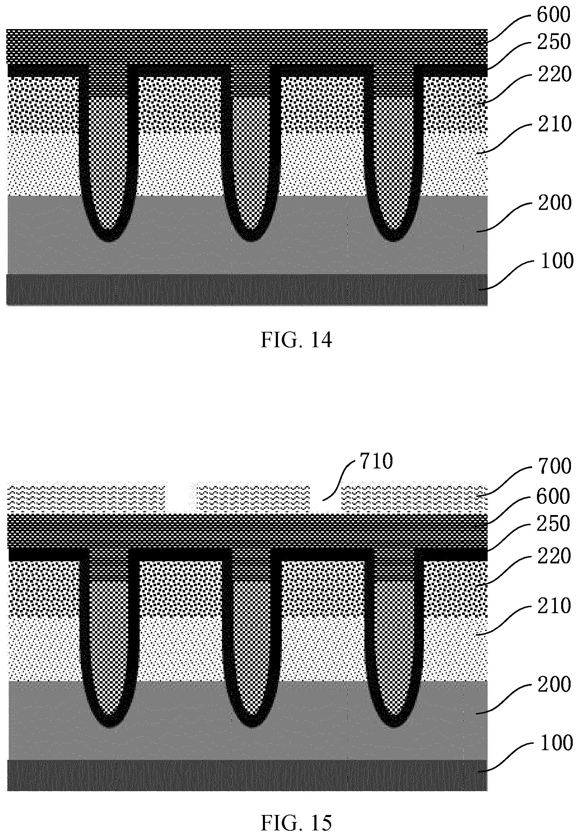

As shown in FIG. 14, the step S610 comprises depositing a dielectric layer 600.

As shown in FIG. 15, the step S620 comprises forming a second mask layer 700 on the dielectric layer 600, and etching on the second mask layer 700 to form contact hole regions 710 by the photolithography process, so as to facilitate subsequent process of etching to form the contact holes 800.

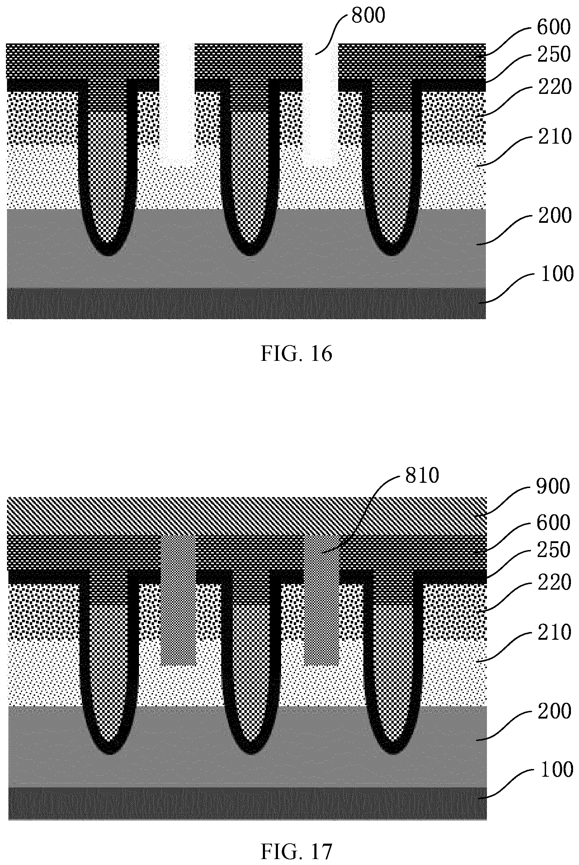

As shown in FIG. 16, the step S630 comprises forming the contact holes 800 through an etching process.

As shown in FIG. 17, the step S640 comprises forming tungsten plugs 810 respectively in the contact holes 800.

As shown in FIG. 17, the step S650 comprises depositing a surface metal layer 900, and enabling the surface metal layer 900 connected with the tungsten plugs 810.

In the present disclosure, the body region 210 is formed by performing the first ion implantation, then the source region 220 is formed by performing the second ion implantation, and the gate trenches 230 are formed by etching, so that a length of conductive channels prepared in the subsequent process is not affected by recessed regions formed by etching polysilicon, and portions of the source region 220 near the gate trenches 230 are prevented from being too deep, thereby avoiding that the conductive channels being too short. Thus, electric leakage of the conductive channels is avoided.

The temperature and the time of the high-temperature processes are reduced by process improvement, and a situation that irons implanted to the body region 210 and the source region 220 may further diffused when the high-temperature processes are performed is avoided, even the body region 210 and the source region 220 are formed in advance by performing the first ion implantation and the second ion implantation. By respectively checking the thicknesses of the portions of the gate oxide layer at the gate trenches 230 corresponding to the source region 220 and the thicknesses of the portions of the gate oxide layer at the gate trenches 230 corresponding to the body region 210, it is avoided that the thicknesses of portions of the the gate oxide layer corresponding to the body region 210 being inconsistent with the thicknesses of portions of the the gate oxide layer corresponding to the source region when performing the first ion implantation and the second ion implantation in advance to form the body region 210 and the source region 220, thereby ensuring that the thickness of the thinnest portion of the gate oxide layer being not less than the minimum design thickness of the gate oxide layer 250.

The present disclosure further provides the short-channel MOSFET device with low turn-on voltage. The short-channel MOSFET device with low turn-on voltage is manufactured by the method described above. The short-channel MOSFET device with low turn-on voltage made by the method avoids a situation where the source region 220 is too deep near the gate trenches 230, thereby avoiding the electric leakage caused by too-short conductive channels after optimizing the on-resistance by reducing the length of the conductive channels.

The above embodiments are optional embodiments of the present disclosure, and the description thereof is relatively specific and detailed, which should not be understood as a limitation on the protection scope. It should be pointed out that for those skilled in the art, several deformations and improvements can be made without departing from the concept of the present disclosure, which are within the protection scope of the present disclosure. Therefore, the protection scope of the present disclosure shall be determined based on the attached claims.

## Claims

1. A method for manufacturing a short-channel metal-oxide-semiconductor field-effect transistor (MOSFET) device with low turn-on voltage, comprising following steps:
S100: providing a silicon wafer (100), and sequentially growing an epitaxial layer (200) and a first oxide layer (300) on the silicon wafer (100);
S200: performing a first ion implantation and a second ion implantation on an upper portion of the epitaxial layer (200) to form a body region (210) and a source region (220);
S300: etching to form gate trenches (230);
S400: growing a gate oxide layer (250) on trench walls of the gate trenches (230);
S500: forming gate polysilicon (500) in the gate trenches (230); and
S600: completing a subsequent manufacturing process of the short-channel MOSFET device.

2. The method according to claim 1, wherein after the source region (220) is formed by the second ion implantation, a temperature and a time of subsequent high-temperature processes for forming a sacrificial oxide layer (240) and the gate oxide layer (250) are reduced.

3. The method according to claim 1, wherein a minimum design thickness of the gate oxide layer (250) is determined according to a gate withstand voltage requirement of the short-channel MOSFET device, and in the step S400, thicknesses of portions of the gate oxide layer (250) disposed on the gate trenches (230) and corresponding to the source region (220) and thicknesses of portions of the gate oxide layer (250) disposed on the gate trenches (230) and corresponding to the body region (210) are not less than the minimum design thickness of the gate oxide layer (250).

4. The method according to any one of claims 1-3, wherein the step of performing the first ion implantation and the second ion implantation on the upper portion of the epitaxial layer (200) to form the body region (210) and the source region (220) comprises steps:
S210: performing the first ion implantation on the upper portion of the epitaxial layer (200) to form the body region (210), and performing a well drive-in process to activate the body region (210); and
S220: performing the second ion implantation on an upper portion of the body region (210) to form the source region (220).

5. The method according to claim 4, wherein the step of etching to form the gate trenches (230) comprises steps:
S310: growing a hard mask layer as a first mask layer (400);
S320: etching on the first mask layer (400) to form gate trench regions (410) by a photolithography process;
S330: etching downward in the gate trench regions (410) by an etching process to form the gate trenches (230); and
S340: removing the first oxide layer (300) and the first mask layer (400).

6. The method according to claim 5, wherein the step of growing the gate oxide layer (250) on the trench walls of the gate trenches (230) comprises steps;
S410: growing a second oxide layer on the trench walls of the gate trenches (230) to form a sacrificial oxide layer (240);
S420: etching to remove the sacrificial oxide layer (240); and
S430: growing a third oxide layer on the trench walls of the gate trenches (230) to form the gate oxide layer (250).

7. The method according to claim 6, wherein when forming the sacrificial oxide layer (240) and when forming the gate oxide layer (250), the temperature for growing the second oxide layer and the third oxide layer is 800-900°C, and the time required for growing the second oxide layer and the third oxide layer is shortened by adding a catalyst.

8. The method according to claim 6, wherein the step of forming the gate polysilicon (500) in the gate trenches (230) comprises steps:
S510: depositing polysilicon (500) to enable the polysilicon (500) to fill the gate trenches (230); and
S520: removing portions of the polysilicon (500) outside the gate trenches (230) by dry etching.

9. The method according to claim 1, wherein the subsequent manufacturing process of the short-channel MOSFET device comprises steps:
S610: depositing a dielectric layer;
S620: etching to form contact hole regions (710) through a photolithography process;
S630: etching on the contact hole regions (710) to form contact holes (800);
S640: forming tungsten plugs (810) respectively in the contact holes (800); and
S650: depositing a surface metal layer. (900)

10. A short-channel MOSFET device with low turn-on voltage, wherein the short-channel MOSFET device is manufactured by the method according to any one of claims 1-9.

## Amended claims

### Amended claims in accordance with Rule 137(2) EPC.

1. A method for manufacturing a short-channel metal-oxide-semiconductor field-effect transistor (MOSFET) device with low turn-on voltage, comprising following steps:
S100: providing a silicon wafer (100), and sequentially growing an epitaxial layer (200) and a first oxide layer (300) on the silicon wafer (100);
S200: performing a first ion implantation and a second ion implantation on an upper portion of the epitaxial layer (200) to form a body region (210) and a source region (220);
S300: etching to form gate trenches (230);
S400: growing a gate oxide layer (250) on trench walls of the gate trenches (230); wherein after the source region (220) is formed by the second ion implantation, a temperature and a time of subsequent high-temperature processes for forming a sacrificial oxide layer (240) and the gate oxide layer (250) are reduced; wherein when forming the sacrificial oxide layer (240) and when forming the gate oxide layer (250), the temperature for growing the oxide layers is 800-900°C, and the time required for growing the oxide layers is shortened by adding a catalyst; wherein a minimum design thickness of the gate oxide layer (250) is determined according to a gate withstand voltage requirement of the short-channel MOSFET device, and in the step S400, thicknesses of portions of the gate oxide layer (250) disposed on the gate trenches (230) and corresponding to the source region (220) and thicknesses of portions of the gate oxide layer (250) disposed on the gate trenches (230) and corresponding to the body region (210) are not less than the minimum design thickness of the gate oxide layer (250);
S500: forming gate polysilicon (500) in the gate trenches (230); and
S600: completing a subsequent manufacturing process of the short-channel MOSFET device.

2. The method according to claim 1, wherein the step of performing the first ion implantation and the second ion implantation on the upper portion of the epitaxial layer (200) to form the body region (210) and the source region (220) comprises steps:
S210: performing the first ion implantation on the upper portion of the epitaxial layer (200) to form the body region (210), and performing a well drive-in process to activate the body region (210); and
S220: performing the second ion implantation on an upper portion of the body region (210) to form the source region (220).

3. The method according to claim 2, wherein the step of etching to form the gate trenches (230) comprises steps:
S310: growing a hard mask layer as a first mask layer (400);
S320: etching on the first mask layer (400) to form gate trench regions (410) by a photolithography process;
S330: etching downward in the gate trench regions (410) by an etching process to form the gate trenches (230); and
S340: removing the first oxide layer (300) and the first mask layer (400).

4. The method according to claim 3, wherein the step of growing the gate oxide layer (250) on the trench walls of the gate trenches (230) comprises steps;
S410: growing a second oxide layer on the trench walls of the gate trenches (230) to form a sacrificial oxide layer (240);
S420: etching to remove the sacrificial oxide layer (240); and
S430: growing a third oxide layer on the trench walls of the gate trenches (230) to form the gate oxide layer (250).

5. The method according to claim 4, wherein the step of forming the gate polysilicon (500) in the gate trenches (230) comprises steps:
S510: depositing polysilicon (500) to enable the polysilicon (500) to fill the gate trenches (230); and
S520: removing portions of the polysilicon (500) outside the gate trenches (230) by dry etching.

6. The method according to claim 1, wherein the subsequent manufacturing process of the short-channel MOSFET device comprises steps:
S610: depositing a dielectric layer;
S620: etching to form contact hole regions (710) through a photolithography process;
S630: etching on the contact hole regions (710) to form contact holes (800);
S640: forming tungsten plugs (810) respectively in the contact holes (800); and
S650: depositing a surface metal layer. (900)

7. A short-channel MOSFET device with low turn-on voltage, wherein the short-channel MOSFET device is manufactured by the method according to any one of claims 1-6.
